# EUROPEAN PATENT APPLICATION

(11) **EP 4 368 672 A1**
(43) Date of publication of application: **15.05.2024**
(21) Application number: 22837267.8
(22) Date of filing: 22.03.2022
(51) Int. Cl.: C08L 83/06, C08K 3/013

(54) **SILICONE RESIN COMPOSITION**

(30) Priority: 08.07.2021 JP 2021113312; 13.12.2021 JP 2021201727
(71) Applicant: JNC Corporation, Chiyoda-ku Tokyo 100-8105 (JP)
(72) Inventor: KANNO Yuuto, Ichihara-shi, Chiba 290-8551 (JP); DEYAMA Yoshihiro, Ichihara-shi, Chiba 290-8551 (JP); TANAKA Shugo, Ichihara-shi, Chiba 290-8551 (JP)
(74) Representative: Becker, Eberhard
(86) International application number: PCT/JP2022/012937
(87) International publication number: WO 2023/281845

(57) **Abstract**

Provided is a silicone resin composition which exhibits excellent workability and which maintains fluidity even if filled, to a high degree, with a thermally conductive filler. This silicone resin composition contains: a component (A), an organopolysiloxane which is represented by a formula (1) and has a molecular weight distribution (Mw/Mn) of 1.20 or less; and a component (B), a thermally conductive filler. In the formula (1), R¹ are each independently a monovalent saturated hydrocarbon group or a monovalent aromatic hydrocarbon group, R² is a monovalent saturated hydrocarbon group, X is oxygen or a divalent hydrocarbon group, n is an integer of 1 or more, and a is an integer between 1 and 3.

## Description

### [Technical Field]

The present invention relates to a silicone resin composition.

### [Background Art]

Since many electronic components generate heat during use, it is necessary to remove heat in order to maintain the functions thereof. Particularly, in recent electronic components, because the amount of heat generated due to high integration and high output of circuit boards has also increased, heat countermeasures have become an important issue.

As a method of removing heat from an electronic component, for example, a method of releasing heat from an electronic component by interposing a thermally conductive material such as thermally conductive grease or a sheet between an electronic component and a cooling member such as a heat sink has been proposed. As one of such thermally conductive materials, a silicone resin composition composed of an organopolysiloxane and a thermally conductive filler such as aluminum oxide powder or zinc oxide powder is used (refer to Patent Literature 1, Patent Literature 2, and Patent Literature 3).

The Bruggeman model is known as a formula for predicting the thermal conductivity of the above thermally conductive material. The formula indicates that, when the filling rate of the thermally conductive filler is low, the thermal conductivity hardly changes regardless of the filling rate, but increases sharply at a certain filling rate or higher. That is, in order to increase the thermal conductivity, it is important how much thermally conductive filler is filled.

On the other hand, there are problems that, when the filling rate of the thermally conductive filler increases, the fluidity of the resin composition used for the thermally conductive material is significantly reduced, and not only does it become difficult to discharge or apply the resin composition, but it is also not possible to conform to fine irregularities on the surface of the electronic component and the heat sink, and the contact thermal resistance increases. As a method of solving this problem, a method of using an additive for improving dispersibility of the thermally conductive filler in the resin composition is known.

### [Citation List]

### [Patent Literature]

[Patent Literature 1]
   Japanese Patent Laid-Open No. 2005-054099
[Patent Literature 2]
   Japanese Patent Laid-Open No. 2004-091743
[Patent Literature 1]
   Japanese Patent Laid-Open No. 2000-063873

### [Summary of Invention]

### [Technical Problem]

The objective of the present invention is to provide a silicone resin composition that maintains fluidity even with filling of a large amount of a thermally conductive filler, and not only has good workability but also has high heat dissipation performance by conforming to surface irregularities of an electronic component and the like and reducing contact thermal resistance.

### [Solution to Problem]

The inventors conducted extensive studies in order to achieve the above objective, and as a result, found that a combination of silicone resin compositions containing an organopolysiloxane having a specific structure and a molecular weight distribution (Mw/Mn) of 1.20 or less and a thermally conductive filler is beneficial and completed the present invention.

That is, according to the present invention, a silicone resin composition shown below is provided.
Aspect 1. A silicone resin composition, including:
   a component (A): an organopolysiloxane represented by Formula (1) and having a molecular weight distribution (Mw/Mn) of 1.20 or less; and
   a component (B): a thermally conductive filler: 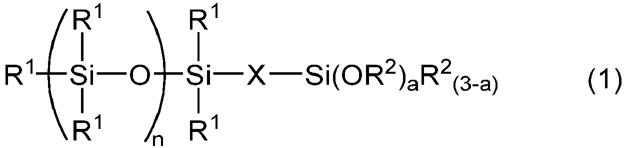 in Formula (1), R¹ are each independently, a monovalent saturated hydrocarbon group or a monovalent aromatic hydrocarbon group, R² are each independently a monovalent saturated hydrocarbon group, X is oxygen or a divalent hydrocarbon group, n is an integer of 1 or more, and a is an integer of 1 to 3.
Aspect 2. The silicone resin composition according to Aspect 1,
   wherein, in Formula (1), the number-average molecular weight (Mn) is 12,000 or less.
Aspect 3. The silicone resin composition according to Aspect 1 or 2,
   wherein, in Formula (1), the number-average molecular weight (Mn) is 7,000 or less.
Aspect 4. The silicone resin composition according to any one of Aspects 1 to 3,
   wherein, in Formula (1), the number-average molecular weight (Mn) is 2,000 or more and 7,000 or less.
Aspect 5. The silicone resin composition according to any one of Aspects 1 to 4,
   wherein, in Formula (1), X is a divalent hydrocarbon group.
Aspect 6. The silicone resin composition according to any one of Aspects 1 to 5,
   wherein the content of the component (A) with respect to 100 parts by mass of the component (B) is 10 parts by mass or less.
Aspect 7. The silicone resin composition according to any one of Aspects 1 to 6, including
   a component (C): an organopolysiloxane other than the component (A).
Aspect 8. The silicone resin composition according to Aspect 7,
   wherein the content of the component (A) with respect to 100 parts by mass of the component (B) is 10 parts by mass or less, and the content of the component (C) with respect to 100 parts by mass of the component (B) is 30 parts by mass or less.

### [Advantageous Effects of Invention]

A silicone resin composition of the present invention maintains fluidity even with filling of a large amount of a thermally conductive filler and thus has excellent workability. In addition, it has high heat dissipation performance because it conforms to surface irregularities of an electronic component and a heat sink.

### [Description of Embodiments]

Hereinafter, embodiments of the present invention will be described below, but the present invention is not limited to the following embodiments.

### [Component (A)]

A component (A) is an organopolysiloxane represented by Formula (1) and having an alkoxysilyl group at one end.

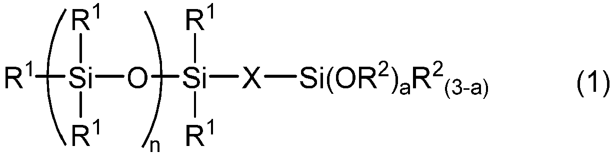

In Formula (1), R¹ are each independently, a monovalent saturated hydrocarbon group or a monovalent aromatic hydrocarbon group, R² are each independently a monovalent saturated hydrocarbon group, X is oxygen or a divalent hydrocarbon group, n is an integer of 1 or more, and a is an integer of 1 to 3.

Examples of monovalent saturated hydrocarbon groups include straight-chain alkyl groups, branched-chain alkyl groups, and cyclic alkyl groups. Examples of straight-chain alkyl groups include methyl, ethyl, propyl, and n-butyl groups. Examples of branched-chain alkyl groups include isopropyl, isobutyl, tert-butyl, and 2-ethylhexyl groups. Examples of cyclic alkyl groups include cyclopentyl and cyclohexyl groups. Examples of monovalent aromatic hydrocarbon groups include phenyl and tolyl groups.

Preferable examples of divalent hydrocarbon groups include straight-chain alkylene and branched-chain alkylene groups. Examples of straight-chain alkylene groups include methylene, ethylene, propylene, and n-butylene. Examples of branched-chain alkylene groups include methylmethylene and dimethylmethylene.

Examples of alkoxysilyl groups include trimethoxysilyl, triethoxysilyl, tripropoxysilyl, methyldimethoxysilyl, methyldiethoxysilyl, ethyldimethoxysilyl, ethyldiethoxysilyl, propyldimethoxysilyl, propyldiethoxysilyl, dimethylmethoxysilyl, dimethylethoxysilyl, diethylmethoxysilyl, diethylethoxysilyl, dipropylmethoxysilyl, and dipropylethoxysilyl. Among these, trimethoxysilyl is preferable in consideration of affinity with a thermally conductive filler and easy availability of production raw materials.

Examples of preferable examples include an organopolysiloxane represented by Formula (2).

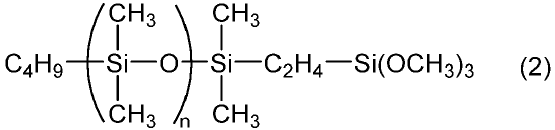

In Formula (2), n is an integer of 1 or more.

When the ratio of the weight-average molecular weight (Mw) and the number-average molecular weight (Mn) of the component (A) in terms of polystyrene measured by a gel permeation chromatography (GPC) method is defined as a molecular weight distribution (Mw/Mn), Mw/Mn needs to be 1.20 or less. If the molecular weight distribution (Mw/Mn) is within this range, the content of a high-molecular-weight component or a low-molecular-weight component that inhibits dispersion is reduced, and the component (B) can be stably dispersed. Therefore, it is possible to obtain a silicone resin composition having excellent fluidity.

In order to obtain a silicone resin composition having better fluidity, Mn of the component (A) is preferably 12,000 or less, more preferably 7,000 or less, and still more preferably 2,000 or more and 7,000 or less.

### [Component (B)]

A component (B) functions as a thermally conductive filler in the silicone resin composition of the present invention. The components (B) may be used alone or two or more thereof may be used in combination.

Specific examples of components (B) include aluminum oxide, aluminum nitride, boron nitride, zinc oxide, diamond, graphene, graphite, carbon nanotubes, carbon fibers, glass fibers, and combinations of two or more thereof. There are no particular restrictions on the filler of the component (B) regarding the crystal form, the particle size, the surface conditions, the presence or absence of the surface treatment, and the like.

Among these, aluminum oxide, aluminum nitride, boron nitride, and zinc oxide are preferable. The particle size is preferably 1 to 200 µm, and a form in which thermally conductive fillers with different particle sizes are used in combination is also preferable.

### [Component (C)]

In the composition of the present invention, additionally, as a component (C), an organopolysiloxane other than the component (A) can be added. The component (C) is appropriately used for adjusting the viscosity of the silicone resin composition of the present invention, imparting curability, heat resistance, and insulation. The components (C) may be used alone or two or more thereof may be used in combination, and may be non-curable or curable by heat, moisture or active energy ray emission.

Specific examples of components (C) include dimethylpolysiloxane, methylphenylpolysiloxane, methylhydrogenpolysiloxane, amino-modified polysiloxane, epoxy-modified polysiloxane, carboxy-modified polysiloxane, carbinol-modified polysiloxane, polyether-modified polysiloxane, alkyl-modified polysiloxane, alkenyl-modified polysiloxane, fluorine-modified polysiloxane, and combinations of two or more thereof.

In the silicone resin composition of the present invention, with respect to 100 parts by mass of the component (B), the content of the component (A) is preferably 0.1 to 50 parts by mass, more preferably 0.1 to 30 parts by mass, still more preferably 0.1 to 10 parts by mass, and particularly preferably 1 to 5 parts by mass. If the content of the component (A) with respect to 100 parts by mass of the component (B) is within this range, the component (B) can be stably dispersed, and the filling rate of the component (B) can be sufficiently secured by restricting excess addition, and thus sufficient heat dissipation is obtained.

When the component (C) is added, the content of the component (C) with respect to 100 parts by mass of the component (B) is preferably 1 to 50 parts by mass, more preferably 1 to 30 parts by mass, still more preferably 5 to 30 parts by mass, and particularly preferably 5 to 15 parts by mass. When the content of the component (C) with respect to 100 parts by mass of the component (B) is within this range, it is possible to adjust the viscosity range in the composition, sufficiently secure effects such as heat resistance, and secure the filling rate of the component (B).

Various additives such as other surfactants, plasticizers, antifoaming agents, and curing agents can be added to the silicone resin composition of the present invention as long as the intended purpose is not impaired.

The viscosity of the silicone resin composition varies depending on the type and content of the components, but since the component (A) of the present invention can stably disperse the component (B), when the component (A) of the present invention is used with the component (B), and the component (C) under the same conditions, the viscosity of the composition can be further reduced and the fluidity becomes better.

The silicone resin composition of the present invention can be produced by kneading the component (A), the component (B) and optionally, the component (C) and various additives using a kneader or the like.

### [Examples]

Hereinafter, the present invention will be described in more detail. Here, in examples, "parts" and "%" are both based on mass (parts by mass, mass%) unless otherwise specified. In addition, the present invention is not limited to these examples.

### <Measurement of molecular weight>

The molecular weight of the organopolysiloxane was measured by a gel permeation chromatography (GPC) method, and the ratio of the weight-average molecular weight (Mw) to the number-average molecular weight (Mn) was defined as a molecular weight distribution (Mw/Mn). Using polystyrene as a standard sample, the molecular weight in terms of polystyrene was measured. Here, measurement of the molecular weight in terms of polystyrene by the GPC method was performed under the following measurement conditions.
a) Measurement instrument: HPLC LC-2000Plus series (commercially available from JASCO Corporation)
b) Column: Shodex KF-804L×2 columns
c) Oven temperature: 40°C
d) Eluent: toluene 0.7 mL/min
e) Standard sample: polystyrene
f) Injection amount: 20 µL
g) Concentration: 0.05 g/10 mL
h) Sample preparation: using toluene as a solvent, a sample was stirred at room temperature and dissolved.

### <Preparation of sample for fluidity evaluation>

As a component for comparison with the component (A) or the component (A), organopolysiloxanes (A-1) to (A-4) and (A'-1) to (A'-7) represented by Formula (2) were used. Hereinafter, a component for comparison with the component (A) will be referred to as a component (A'). 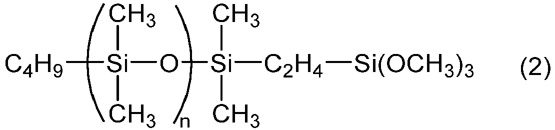 In Formula (2), n is an integer of 1 or more arbitrarily selected to obtain the number-average molecular weight (Mn) shown in Table 1.

**Table 1**

| | | Mn | Mw | Mw/Mn |
|---|---|---|---|---|
| Component (A) | A-1 | 1400 | 1700 | 1.16 |
| | A-2 | 3000 | 3200 | 1.08 |
| | A-3 | 6200 | 6600 | 1.06 |
| | A-4 | 12000 | 12500 | 1.04 |
| Component (A') | A'-1 | 1360 | 2770 | 2.03 |
| | A'-2 | 2830 | 8110 | 2.87 |
| | A'-3 | 3160 | 7880 | 2.49 |
| | A'-4 | 3420 | 7510 | 2.20 |
| | A'-5 | 3960 | 7200 | 1.82 |
| | A'-6 | 4700 | 6870 | 1.46 |
| | A'-7 | 10800 | 13500 | 1.24 |

Compositions of Examples 1 to 12 and Comparative Examples 1 to 7 were obtained by mixing the component (A) or the component (A'), the component (B) and the component (C) in component ratios shown in Tables 2 to 4. That is, in an ointment jar container, the component (A) or the component (A'), the component (B) and the component (C) were weighed out, stirred with a spatula, and then kneaded using an Awatori Rentaro vacuum type (model: ARV-310, commercially available from Thinky Corporation) at 2,000 rpm for 1 minute under atmospheric pressure conditions and at 2,000 rpm for 1 minute under reduced pressure conditions to prepare a composition for fluidity evaluation.

### <Fluidity evaluation>

The viscosity of the composition sample for fluidity evaluation prepared as described above was measured using a rotational viscometer (TV-22 commercially available from Toki Sangyo Co., Ltd.) under the following conditions to evaluate fluidity. The viscosities were listed in Tables 2 to 4 together with the component ratios.
a) Cone rotor: 3°×R14
b) Temperature: 25±1°C
c) Rotational speed: 1 rpm

**Table 2**

| Component ratio (parts by mass) | | Example | | | | | |
|---|---|---|---|---|---|---|---|
| | | 1 | 2 | 3 | 4 | 5 | 6 |
| Component (A) | A-1 | 4.0 | | | | 1.0 | 3.0 |
| | A-2 | | 4.0 | | | | |
| | A-3 | | | 4.0 | | | |
| | A-4 | | | | 4.0 | | |
| Component (B) | DAW-10^{*1} | 100.0 | 100.0 | 100.0 | 100.0 | | |
| | DAW-45^{*2} | | | | | 60.0 | 60.0 |
| | DAW-03^{*3} | | | | | 40.0 | 40.0 |
| Component (C) | KF-96 300CS^{*4} | 9.9 | 9.9 | 9.8 | 9.9 | 12.9 | 10.9 |
| Composition viscosity (Pa·s) | | 20.9 | 17.0 | 18.8 | 25.8 | 19.4 | 12.9 |

**Table 3**

| Component ratio (parts by mass) | | Example | | | | | |
|---|---|---|---|---|---|---|---|
| | | 7 | 8 | 9 | 10 | 11 | 12 |
| Component (A) | A-1 | | | | | | |
| | A-2 | 1.0 | 3.0 | | | | |
| | A-3 | | | 1.0s | 3.0 | | |
| | A-4 | | | | | 1.0 | 3.0 |
| Component (B) | DAW-45^{*2} | 60.0 | 60.0 | 60.0 | 60.0 | 60.0 | 60.0 |
| | DAW-03^{*3} | 40.0 | 40.0 | 40.0 | 40.0 | 40.0 | 40.0 |
| Component (C) | KF-96 300CS^{*4} | 12.9 | 10.9 | 12.9 | 11.0 | 12.9 | 10.9 |
| Composition viscosity (Pa·s) | | 14.8 | 11.0 | 13.6 | 10.8 | 20.6 | 14.8 |

**Table 4**

| Component ratio (parts by mass) | | Comparative Example | | | | | | |
|---|---|---|---|---|---|---|---|---|
| | | 1 | 2 | 3 | 4 | 5 | 6 | 7 |
| Component (A') | A'-1 | 4.0 | | | | | | |
| | A'-2 | | 4.0 | | | | | |
| | A'-3 | | | 4.0 | | | | |
| | A'-4 | | | | 4.0 | | | |
| | A'-5 | | | | | 4.0 | | |
| | A'-6 | | | | | | 4.0 | |
| | A'-7 | | | | | | | 4.0 |
| Component (B) | DAW-10^{*1} | 100.0 | 100.0 | 100.0 | 100.0 | 100.0 | 100.0 | 100.0 |
| Component (C) | KF-96 300CS^{*4} | 9.9 | 9.9 | 9.8 | 9.9 | 9.9 | 9.9 | 9.8 |
| Composition viscosity (Pa·s) | | 22.8 | 24.9 | 24.6 | 23.2 | 22.2 | 20.5 | 27.8 |

| | | | | | | | | |
|---|---|---|---|---|---|---|---|---|
| *1 spherical alumina with an average diameter of 13 µm (DAW-10 commercially available from Denka Co., Ltd.) *2 spherical alumina with an average diameter of 45 µm (DAW-45 commercially available from Denka Co., Ltd.) *3 spherical alumina with an average diameter of 5 µm (DAW-03 commercially available from Denka Co., Ltd.) *4 dimethylpolysiloxane (KF-96-300CS commercially available from Shin-Etsu Chemical Co., Ltd.) | | | | | | | | |

Regarding the viscosity of the composition, comparing examples in which the values Mn of the component (A) and the component (A') were close (for example, between Example 1 and Comparative Example 1, between Example 2 and Comparative Example 2 or 3, between Example 4 and Comparative Example 7), the results were that the composition to which the component (A) with an Mw/Mn of 1.20 or less was added had a lower composition viscosity and better fluidity than the composition to which the component (A') with an Mw/Mn of more than 1.20 was added. It was found that, if Mw/Mn was 1.20 or less, dispersion properties were good and the viscosity could be kept low. As in Comparative Example 6, even if Mw/Mn was 1.50 or less, exceeding 1.20, if Mn was 2,000 to 7,000, the composition had a low viscosity to some extent, but the composition with an Mw/Mn of 1.20 or less had a lower viscosity.

It was found that, among the components (A) with an Mw/Mn of 1.20 or less, the composition with an Mn range of 2,000 to 7,000, had a particularly low viscosity and excellent fluidity.

As described above, it can be concluded that the silicone resin composition of the present invention has excellent workability and heat dissipation performance.

### [Industrial Applicability]

A silicone resin composition of the present invention can be used as a thermally conductive material that is interposed between a heat-generating electronic component such as a transistor, an IC chip, and a memory element and a cooling member such as a heat sink.

## Claims

1. A silicone resin composition, comprising:
a component (A): an organopolysiloxane represented by Formula (1) and having a molecular weight distribution (Mw/Mn) of 1.20 or less; and
a component (B): a thermally conductive filler: 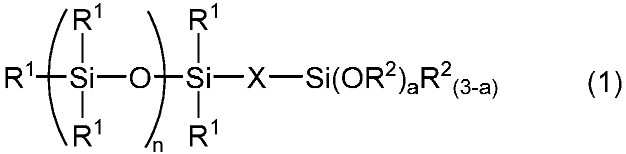
in Formula (1), R¹ are each independently, a monovalent saturated hydrocarbon group or a monovalent aromatic hydrocarbon group, R² are each independently a monovalent saturated hydrocarbon group, X is oxygen or a divalent hydrocarbon group, n is an integer of 1 or more, and a is an integer of 1 to 3.

2. The silicone resin composition according to claim 1,
wherein, in Formula (1), the number-average molecular weight (Mn) is 12,000 or less.

3. The silicone resin composition according to claim 1 or 2,
wherein, in Formula (1), the number-average molecular weight (Mn) is 7,000 or less.

4. The silicone resin composition according to any one of claims 1 to 3,
wherein, in Formula (1), the number-average molecular weight (Mn) is 2,000 or more and 7,000 or less.

5. The silicone resin composition according to any one of claims 1 to 4,
wherein, in Formula (1), X is a divalent hydrocarbon group.

6. The silicone resin composition according to any one of claims 1 to 5,
wherein a content of the component (A) with respect to 100 parts by mass of the component (B) is 10 parts by mass or less.

7. The silicone resin composition according to any one of claims 1 to 6, comprising
a component (C): an organopolysiloxane other than the component (A).

8. The silicone resin composition according to claim 7,
wherein a content of the component (A) with respect to 100 parts by mass of the component (B) is 10 parts by mass or less, and a content of the component (C) with respect to 100 parts by mass of the component (B) is 30 parts by mass or less.
